# EUROPÄISCHE PATENTSCHRIFT

(11) **EP 0 991 079 B1**
(45) Veröffentlichungstag und Bekanntmachung des Hinweises auf die Patenterteilung: **28.06.2006**
(21) Anmeldenummer: 99119287.3
(22) Anmeldetag: 28.09.1999
(51) Int. Cl.: G11C 11/22

(54) **Integrierter Speicher**
Integrated memory
Mémoire intégrée

(30) Priorität: 28.09.1998 DE 19844402
(43) Veröffentlichungstag der Anmeldung: 05.04.2000
(73) Patentinhaber: Infineon Technologies AG, 81669 München (DE)
(72) Erfinder: Braun, Georg, 80339 München (DE); Majdic, Andrej, 85604 Zorneding (DE); Mazure-Espejo, Carlos, Dr., 81667 München (DE); Hönigschmid, Heinz, 82319 Starnberg (DE)
(74) Vertreter: Ginzel, Christian

(56) Entgegenhaltungen:
- US-A- 5 270 967
- US-A- 5 745 403
- US-A- 5 777 921
- PATENT ABSTRACTS OF JAPAN vol. 1998, no. 01, 30. Januar 1998 (1998-01-30) & JP 09 245488 A (HITACHI LTD;HITACHI VLSI ENG CORP), 19. September 1997 (1997-09-19)

## Beschreibung

Die Erfindung betrifft einen integrierten Speicher mit beschreibbaren Speicherzellen.

Ferroelektrische Speicher wie zum Beispiel FRAMs beziehungsweise FeRAMs sind beschreibbare integrierte Speicher mit Speicherzellen, die als Speicherelement wenigstens einen ferroelektrischen Kondensator aufweisen. Dieser Kondensator hat als Dielektrikum ein ferroelektrisches Material. Dieses Material kann unterschiedlich polarisiert werden, was dem Speichern unterschiedlicher Informationen entspricht. Das ferroelektrische Material behält seine Polarisation auch, wenn der Speicher von der Versorgungsspannung getrennt wird. Daher handelt es sich bei FRAMs um beschreibbare, nicht-flüchtige Speicher. Allerdings kommt es bei ferroelektrischen Speicherzellen zu Alterungserscheinungen, die dazu führen, daß neue Informationen nicht ohne weiteres gespeichert werden können. So tendieren die Speicherzellen beispielsweise dazu, einen bereits programmierten Zustand beizubehalten (sogenannter "Imprint").

Die US 5,270,967 A betrifft das Entaltern ferroelektrischer Speicherzellen durch Auffrischen ihrer ferroelektrischen Kondensatoren. Das Auffrischen erfolgt dadurch, daß an den Speicherkondensator Spannungen angelegt werden, die größer sind als diejenigen, die während des Normalbetriebs auftreten. Während des Auffrischens werden diese höheren Spannungen mit alternierendem Vorzeichen am Speicherkondensator angelegt. Auf die beschriebene Weise kann der Imprint vermindert werden. Das Auffrischen der Speicherzellen erfolgt dabei jeweils nach einer bestimmten Anzahl von Schreibzugriffen auf die Speicherzellen.

In der US 5,270,967 A wird vor dem Auffrischen einer Speicherzelle deren Inhalt in einem Leseverstärker zwischengespeichert, der anschließend durch einen Schalter von der Speicherzelle getrennt wird. Daraufhin erzeugt eine spezielle Schaltungseinheit die für das Auffrischen erforderlichen alternierenden Spannungen. Nach dem Abschließen des Auffrischens wird der Schalter geschlossen und die im Leseverstärker zwischengespeicherte Information kann zur Herstellung des vorherigen Zustands wieder in die Speicherzelle eingeschrieben werden.

Die beschriebene Vorgehensweise hat den Nachteil, daß durch das Vorsehen der zusätzlichen Schaltungseinheit, die die für das Auffrischen erforderlichen höheren Spannungen erzeugt, der Platzbedarf relativ groß ist.

Die US 5,777,921 beschreibt einen ferroelektrischen Speicher bei dem eine ferroelektrische Speicherzelle mit einem primären Leseverstärker und einem sekundären Leseverstärker über eine Bitleitung und eine invertierende Bitleitung verschaltet ist. Weiterhin sind an jedem Ausgang des Leseverstärkers Schalteinheiten vorgesehen, wobei der jeweilige Ausgang des Leseverstärkers über die eine Schalteinheit mit dem zugehörigen Eingang des Leseverstärkers bzw. über die andere Schalteinheit mit dem jeweiligen anderen Eingang des Leseverstärkers verschaltet ist. Auf diese Weise ermöglicht es die Anordnung der US 5,777,921, die Anschlüsse des Leseverstärkers zu vertauschen. Während eines Auffrischungsvorgangs für die ferroelektrische Speicherzelle wird der logische Wert der Zelle ausgelesen, dann zuerst der invertierte Wert in die Zelle zurückgeschrieben und anschließend der tatsächliche Wert noch einmal geschrieben. Nachdem der invertierte Wert zurückgeschrieben wurde, wird der tatsächliche Wert in die Speicherzelle zurückgeschrieben. Dabei wird die Auffrischung der Speicherzelle nur dann durchgeführt, wenn ein Zähler einen vorbestimmten Wert erreicht hat. Ansonsten werden die Lese- bzw. Schreibvorgänge normal, d.h. ohne Invertieren, ausgeführt.

Der Erfindung liegt daher die Aufgabe zugrunde, einen integrierten Speicher der beschriebenen Art anzugeben, bei dem ein Auffrischen der Speicherzellen mit geringerem Hardware-Aufwand erfolgt.

Diese Aufgabe wird mit einem integrierten Speicher gemäß Anspruch 1 und mit einem Verfahren zum Entaltern seiner Speicherzellen gemäß Patentanspruch 4 gelöst. Vorteilhafte Aus- und Weiterbildungen der Erfindung sind Gegenstand abhängiger Ansprüche.

Der integrierte Speicher weist einen ersten differentiellen Leseverstärker mit Anschlüssen auf, die mit einem Datenleitungspaar verbunden sind, über das der erste Leseverstärker bei einem Lesezugriff eine Information aus einer der Speicherzellen ausliest, um sie anschließend zu verstärken, und über das er bei einem Schreibzugriff eine Information in eine der Speicherzellen einschreibt, wobei die betreffenden Informationen als Differenzsignale über das Datenleitungspaar übertragen werden und bei jedem Schreibzugriff vom ersten Leseverstärker zwischengespeichert werden. Weiterhin weist er eine Schalteinheit auf, über die das Datenleitungspaar mit den Anschlüssen des ersten Leseverstärkers verbunden ist, wobei die Schalteinheit zum Vertauschen der Leitungen des Datenleitungspaares bezüglich der Anschlüsse des ersten Leseverstärkers in Abhängigkeit ihres Schaltzustandes dient. Der Schaltzustand der Schalteinheit wird während eines Schreibzugriffes wenigstens einmal geändert, so daß die einzuschreibende Information vom ersten Leseverstärker zunächst nicht invertiert und dann invertiert in die betreffende Speicherzelle eingeschrieben wird.

Beim erfindungsgemäßen Speicher dient der erste Leseverstärker also nicht nur zum Zwischenspeichern der vor dem Auffrischen in der Speicherzelle gespeicherten Information und Zurückschreiben dieser Information in die Speicherzelle, nachdem das Auffrischen abgeschlossen worden ist, wie dies bei der US 5,270,967 A der Fall ist. Der erste Leseverstärker dient darüber hinaus während des Auffrischens der Zuführung von alternierenden Spannungen, die unterschiedlichen logischen Zuständen zugeordnet sind, zur Speicherzelle, so daß hierfür keine zusätzlichen Schaltungseinheiten notwendig sind. Bekanntlich sorgen differentielle Leseverstärker in integrierten Speichern dafür, daß die Potentiale auf dem mit ihnen verbundenen Datenleitungspaar zueinander komplementär sind, das heißt bei einem Schreib- oder Lesezugriff hat eine der Leitungen des Leitungspaares einen hohen Pegel, der beispielsweise einer logischen "1" entspricht, und die andere Leitung einen niedrigen Pegel, was beispielsweise einer logischen "0" entspricht. Durch das erfindungsgemäße Vertauschen der Zuordnung der Leitungen des Datenleitungspaares bezüglich der Anschlüsse des ersten Leseverstärkers während des Schreibzugriffs ändert sich das Potential auf jeder der beiden Leitungen daher ständig zwischen dem hohen und dem niedrigen Pegel. Auf diese Weise sorgt der Leseverstärker dafür, daß alternierende Spannungen an der Speicherzelle anliegen. Hierdurch wird der Imprint der Speicherzelle verringert.

Günstig ist es, wenn die Anzahl der Wechsel des Schaltzustandes der Schalteinheit während eines Schreibzugriffs geradzahlig ist. Dann ist die Information nach Abschluß des Schreibzugriffs mit ihrem ursprünglichen logischen Zustand in der Speicherzelle gespeichert.

Das Schalten der Schalteinheit kann beispielsweise bei jedem Schreibzugriff auf die Speicherzellen des Speichers erfolgen. Dann erfolgt bei jedem Schreibzugriff automatisch ein Entaltern der Speicherzelle. Allerdings verlängert sich dadurch die für einen Schreibzugriff notwendige Zeit. Daher ist es vorteilhaft, wenn nach einer Weiterbildung der Erfindung der Speicher eine erste Betriebsart hat, in der sich der Schaltzustand der Schalteinheit während eines Schreibzugriffs nicht ändert, und eine zweite Betriebsart, in der sich der Schaltzustand der Schalteinheit während eines Schreibzugriffes wenigstens einmal ändert. In der ersten Betriebsart erfolgt dann ein relativ schneller Schreibzugriff, während der Schreibzugriff in der zweiten Betriebsart länger dauert.

Bei den Schreibzugriffen, während derer sich der Schaltzustand der Schalteinheit ändert, kann es sich entweder um normale Schreibzugriffe handeln, bei denen externe Daten dem Speicher zugeführt und in der Speicherzelle gespeichert werden, oder um spezielle Schreibzugriffe, bei denen zuvor die in der aufzufrischenden Speicherzelle gespeicherte Information ausgelesen, im ersten Leseverstärker zwischengespeichert und anschließend mehrfach, mit alternierenden Potentialen, in die Speicherzelle zurückgeschrieben wird. Um hierbei nach dem Auffrischen die ursprüngliche Information in der Speicherzelle zu haben, wie zuvor, muß nach dem Auslesen der Zelle die Anzahl der Wechsel der Schaltzustände wiederum geradzahlig sein.

In einer Ausführungsform der Erfindung ist der erste Leseverstärker ein primärer Leseverstärker und das Datenleitungspaar ein Bitleitungspaar des Speichers, mit dem der primäre Leseverstärker direkt verbunden ist. Bei dieser Ausführungsform wird dann eine Schalteinheit für jedes Bitleitungpaar benötigt.

Nach einer anderen Ausführungsform der Erfindung ist der erste Leseverstärker ein sekundärer Leseverstärker und der Speicher weist wenigstens zwei zweite Leseverstärker auf, die primäre Leseverstärker sind und die einerseits über wenigstens je ein Paar der Bitleitungen mit den Speicherzellen und andererseits über das Datenleitungspaar mit dem ersten Leseverstärker verbunden sind. Üblicherweise sind bei beschreibbaren integrierten Speichern wie DRAMs oder FRAMs mehrere primäre Leseverstärker über ein Datenleitungspaar mit je einem sekundären Leseverstärker verbunden, der einem weiteren Verstärken von aus den Speicherzellen ausgelesenen Signalen dient. Bei dieser Ausführungsform wird nur je eine Schaltungseinheit pro mit dem sekundären Leseverstärker verbundenem Datenleitungspaar benötigt, so daß die Anzahl der Schalteinheiten geringer ist als bei der zuvor erläuterten Ausführungsform.

Die Erfindung eignet sich vorzugsweise, aber nicht auschließlich zum Entaltern von Speicherzellen eines ferroelektrischen Speichers, die wenigstens einen ferroelektrischen Speicherkondensator aufweisen. Es ist dann günstig, wenn die während eines Schreibzugriffs auf die jeweilige Speicherzelle über ihrem Speicherkondensator abfallende Spannung in der zweiten Betriebsart höher ist als in der ersten Betriebsart. Die höhere Spannung am Speicherkondensator kann zum Beispiel dadurch erreicht werden, daß ein mit dem Bitleitungspaar verbundener erster oder zweiter Leseverstärker in der zweiten Betriebsart mit einer höheren Versorgungsspannung versorgt wird als in der ersten Betriebsart. Dann gibt der Leseverstärker beim Schreiben in der zweiten Betriebsart auf das Bitleitungspaar Differenzsignale mit einer höheren Spannung. Dann liegt beim Schreiben von Daten in eine Speicherzelle an der mit der Bitleitung verbundenen Elektrode ihres Speicherkondensators ein gegenüber der ersten Betriebsart erhöhtes Potential an. Somit ergibt sich aufgrund der höheren Versorgungsspannung des Leseverstärkers eine höhere Spannung am Speicherkondensator der Speicherzelle. Alternativ oder zusätzlich zum Erhöhen der Versorgungsspannung des Leseverstärkers kann aber auch eine von der Bitleitung abgewandte Elektrode des Speicherkondensators der Speicherzelle in der zweiten Betriebsart auf andere Pegel gebracht werden, als in der ersten Betriebsart. Hierdurch kann ebenfalls die Spannung am Speicherkondensator in der zweiten Betriebsart erhöht werden. Dabei kann das Potential an der betreffenden Kondensatorelektrode konstant oder auch gepulst sein.

Die Erfindung wird im folgenden anhand der Figuren näher erläutert.
- Figur 1: zeigt ein erstes Ausführungsbeispiel des integrierten Speichers,
- Figur 2: zeigt ein zweites Ausführungsbeispiel des erfindungsgemäßen Speichers,
- Figur 3: zeigt ein Speicherzellenfeld des Speichers und
- Figur 4: zeigt eine Speicherzelle des Speichers.

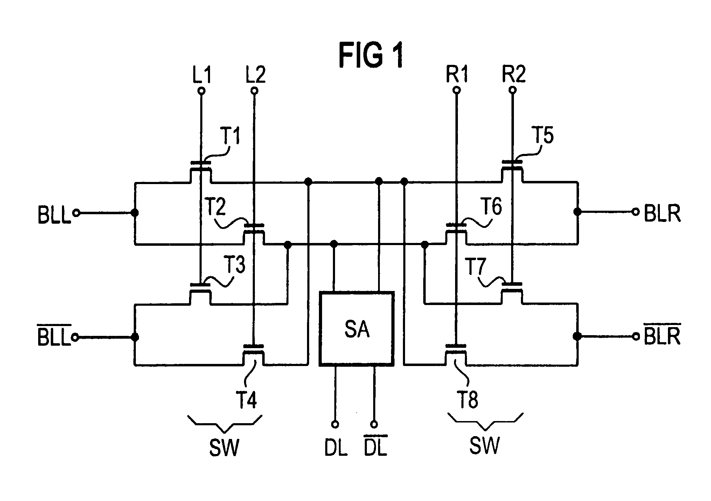

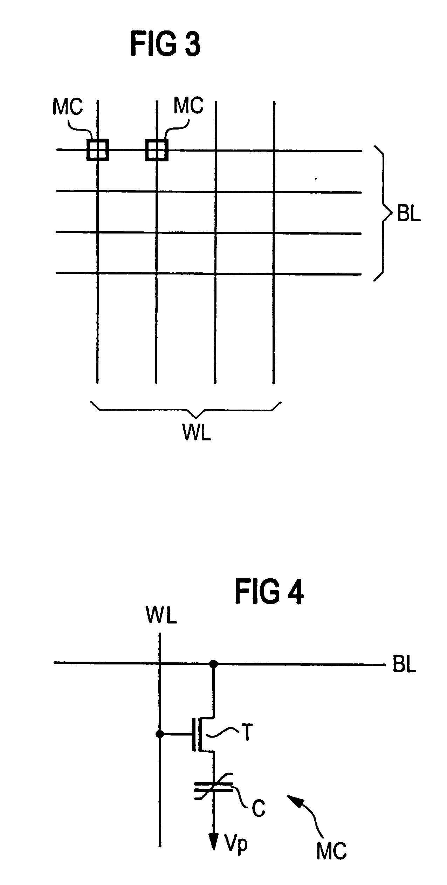

Figur 1 zeigt ein erstes Ausführungsbeispiel des erfindungsgemäßen integrierten Speichers, von dem nur die zum Verständnis der Erfindung notwendigen Komponenten dargestellt wurden. Bei dem hier betrachteten Ausführungsbeispiel handelt es um einen ferroelektrischen Speicher, der gemäß Figur 3 matrixförmig angeordnete Bitleitungen BL und Wortleitungen WL aufweist, in deren Kreuzungspunkten Speicherzellen MC angeordnet sind.

Jede der ferroelektrischen Speicherzellen MC ist so wie in Figur 4 gezeigt aufgebaut. Es handelt sich um Speicherzellen vom 1-Transistor/1-Kondensator-Typ, die über eine der Wortleitungen WL auswählbar sind, und in die Informationen über eine der Bitleitungen BL einschreibbar beziehungsweise aus denen einen gespeicherte Information über die Bitleitungen BL auslesbar sind. Die Bitleitung BL ist über den Hauptstrompfad des Speicherzellentransistors T mit einer ersten Elektrode des ferroelektrischen Speicherkondensators C verbunden. Dessen zweite Elektrode ist mit einem Plattenpotential V_{P} verbunden. Das Gate des Speicherzellentransistors ist mit einer der Wortleitungen WL verbunden. Je nach Typ der Speicherzelle MC liegt das Plattenpotential V_{P} entweder fest auf einem Mittelwert, der sich zwischen den beiden Versorgungspotentialen des Speichers befindet (zum Beispiel V_{CC}/2), oder das Plattenpotential V_{P} pulsiert bei jedem Schreib- oder Lesezugriff auf die Speicherzelle MC.

Gemäß Figur 1 werden Informationen von und zu den Speicherzellen, wie bei DRAMs und FRAMs üblich, als Differenzsignale über Bitleitungspaare BLL, /BLL; BLR, /BLR übertragen. Je zwei Bitleitungspaaren ist ein differentieller primärer Leseverstärker SA zugeordnet, der bei einem Lesezugriff zum Verstärken des Differenzsignals dient, das sich auf einem der Bitleitungspaare ausbildet. Der primäre Leseverstärker SA gibt das verstärkte Differenzsignal auf ein Datenleitungspaar DL, /DL weiter. Bei einem Schreibzugriff werden einzuschreibende Informationen in umgekehrter Richtung von den Datenleitungen DL, /DL, dem Leseverstärker SA und eines der Bitleitungspaare BLL, /BLL zur entsprechenden Speicherzelle übertragen.

Bei einem Zugriff auf eine der Speicherzellen MC erfolgt einen Adressierung der ihr zugeordneten Wortleitung WL und Bitleitung BL über entsprechende an den Speicher anlegbare Adressen. Vor dem Auslesen werden die beiden Leitungen des Bitleitungspaares BLL, /BLL auf das gleiche Potential vorgeladen. Bei einem Lesezugriff wird die Information der Speicherzelle auf die nicht invertierte Bitleitung BLL ausgelesen, während die invertierte Bitleitung /BLL ein definiertes Potential aufweist, mit dem der primäre Leseverstärker SA das Potential auf der nicht invertierten Bitleitung BLL vergleicht. Ist das Potential nach dem Auslesen der Speicherzelle MC auf der nicht invertierten Bitleitung BLL größer als auf der invertierten Bitleitung /BLL, verstärkt der differentielle primäre Leseverstärker SA diese Potentialdifferenz und erzeugt auf der nicht invertierten Bitleitung BLL einen hohen Pegel (VCC). Ist dagegen nach dem Auslesen der Speicherzelle MC das Potential auf der nicht invertierten Bitleitung BLL niedriger als auf der invertierten Bitleitung /BLL, verstärkt der primäre Leseverstärker das Signal auf der nicht invertierten Bitleitung BLL auf einen niedrigen Pegel (Masse). Der primäre Leseverstärker SA erzeugt auf der invertierten Bitleitung /BLL den jeweils zum Potential der nicht invertierten Bitleitung BLL inversen logischen Zustand. Das soeben beschriebene Prinzip ist dem Fachmann von DRAMs und FRAMs bekannt und daher wird an dieser Stelle nicht weiter darauf eingegangen.

Der primäre Leseverstärker SA in Figur 1 weist zwei Anschlüsse auf, die einerseits einem linken Bitleitungspaar BLL, /BLL und andererseits einem rechten Bitleitungspaar BLR, /BLR zugeordnet sind, die verschiedenen Zellenfeldern angehören (shared sense amplifier concept). Ein erster Anschluß des primären Leseverstärkers ist über einen ersten Transistor T1 und ein zweiter Anschluß des Leseverstärkers ist über einen zweiten Transistor T2 mit der nicht invertierten linken Bitleitung BLL verbunden. Der zweite Anschluß ist außerdem über einen dritten Transistor T3 und der erste Anschluß über einen vierten Transistor T4 mit der invertierten linken Bitleitung /BLL verbunden. Außerdem ist der erste Anschluß über einen fünften Transistor T5 und der zweite Anschluß über einen sechsten Transistor T6 mit der nicht invertierten rechten Bitleitung BLR verbunden. Der zweite Anschluß ist über einen siebten Transistor T7 und der erste Anschluß über einen achten Transistor T8 mit der invertierten rechten Bitleitung /BLR verbunden. Bei diesem Ausführungsbeispiel ist der primäre Leseverstärker SA zwei Speicherzellenfeldern zugeordnet, nämlich einem linken und einem rechten. Durch entsprechende Ansteuerung der acht Transistoren sind seine Anschlüsse entweder mit dem linken Bitleitungspaar BLL, /BLL verbunden, das sich im linken Speicherzellenfeld befindet, oder mit dem rechten Bitleitungspaar BLR, /BLR, das sich im rechten Speicherzellenfeld befindet.

Die acht Transistoren T1 bis T8 in Figur 1 sind vom n-Kanal-Typ. Die Gates des ersten Transistors T1 und des dritten Transistors T3 sind mit einer ersten Steuerleitung L1 verbunden. Die Gates des zweiten Transistors T2 und des vierten Transistors T4 sind mit einer zweiten Steuerleitung L2 verbunden. Die Gates des sechsten Transistors T6 und des achten Transistors T8 sind mit einer dritten Steuerleitung R1 verbunden. Die Gates des fünften Transistors T5 und des siebten Transistors T7 sind mit einer vierten Steuerleitung R2 verbunden.

Die ersten vier Transistoren T1 bis T4 bilden eine erste Schalteinheit SW und die übrigen vier Transistoren T5 bis T8 bilden eine zweite Schalteinheit SW. Die Transistoren jeder Schalteinheit SW dienen dazu, die Zuordnung der Leitungen des jeweiligen Bitleitungspaares BLL, /BLL zu den Anschlüssen des primären Leseverstärkers SA zu vertauschen. Die der jeweiligen Schalteinheit SW zugeordneten Steuerleitungen L1, L2 beziehungsweise R1, R2 weisen daher drei verschiedene Zustände auf. Entweder befindet sich auf beiden Steuerleitungen L1, L2 ein niedriges Potential, so daß alle zugehörigen Transistoren T1 bis T4 gesperrt sind. Außerdem kann entweder die erste oder die zweite Steuerleitung einen hohen Pegel aufweisen.

Weisen beide Steuerleitungen L1, L2 einen niedrigen Pegel auf, dann ist der primäre Leseverstärker SA von diesem Bitleitungspaar BLL, /BLL getrennt. Er kann dann beispielsweise Daten von oder zum rechten Bitleitungspaar BLR, /BLR übertragen, wenn die dritte R1 oder vierte R2 Steuerleitung entsprechend angesteuert wird.

In einer ersten Betriebsart des Speichers ist das Potential auf der ersten Steuerleitung L1 bei einem Schreib- oder Lesezugriff auf eine mit dem linken Bitleitungspaar BLL, /BLL verbundene Speicherzelle immer hoch, während das Potential auf der zweiten Steuerleitung L2 immer niedrig ist. Die Zuordnung der Anschlüsse des primären Leseverstärkers SA zu den beiden Leitungen des Bitleitungspaares BLL, /BLL bleibt in der ersten Betriebsart konstant.

Der Speicher hat außerdem eine zweite Betriebsart, in der das Potential auf der ersten Steuerleitung L1 und auf der zweiten Steuerleitung L2 sich ständig ändert, so daß einmal der erste Transistor T1 und der dritte Transistor T3 leiten und der zweite Transistor T2 und der vierte Transistor T4 sperren und anschließend der zweite Transistor T2 und der vierte Transistor T4 leiten und der erste Transistor T1 und der dritte Transistor T3 sperren. Dieser Wechsel erfolgt in der zweiten Betriebsart bei einem Schreibzugriff auf eine der Speicherzellen MC des entsprechenden Bitleitungspaares. Bei diesem Ausführungsbeispiel geht dem Schreibzugriff in der zweiten Betriebsart ein Lesezugriff auf die entsprechende Speicherzelle MC voraus. Dabei wird die in der Speicherzelle gespeicherte Information über das Bitleitungspaar BLL, /BLL zum primären Leseverstärker SA übertragen und dort zwischengespeichert. Der primäre Leseverstärker SA ist dabei wie bei DRAMs oder FRAMs üblich gestaltet. Eine Ausführungsform des primären Leseverstärkers SA ist beispielsweise in der schon erwähnten US 5,270,967 dargestellt. Der Leseverstärker SA verstärkt die aus der Speicherzelle MC ausgelesene Information, so daß anschließend auf dem Bitleitungspaar BLL, /BLL entgegengesetzte Versorgungspotentialpegel des Speichers anliegen. Während dieses Lesezugriffs weist die erste Steuerleitung L1 ein hohes und die zweite Steuerleitung L2 ein niedriges Potential auf. Nachdem die somit ausgelesene Information im primären Leseverstärker SA zwischengespeichert worden ist, werden die Potentiale auf den beiden Steuerleitungen L1, L2 ständig vertauscht, so daß das Differenzsignal an den Anschlüssen des Leseverstärkers SA immer mit jeweils umgekehrtem Vorzeichen an das Bitleitungspaar BLL, /BLL übermittelt wird. Somit wird erreicht, daß ständig alternierende Spannungen an der jeweils ausgewählten Speicherzelle MC anliegen.

Da der primäre Leseverstärker SA in Figur 1 in der zweiten Betriebsart die aus der Speicherzelle zuvor ausgelesene Information zwischenspeichert, wird diese in Abhängigkeit vom Schaltzustand der Schalteinheit SW entweder invertiert oder nicht invertiert in die Speicherzelle MC zurückgeschrieben.

Während des Auffrischens einer der Speicherzellen MC über das linke Bitleitungspaar BLL, /BLL in Figur 1 weisen die dritte und vierte Steuerleitung R1, R2 ein niedriges Potential auf, so daß das rechte Bitleitungspaar BLR, /BLR vom primären Leseverstärker SA abgekoppelt ist. Ein Zugriff auf das rechte Bitleitungspaar erfolgt analog durch Abkoppeln des linken Bitleitungspaares BLL, /BLL, indem die ersten beiden Steuerleitungen L1, L2 ein niedriges Potential aufweisen. Die vier Steuerleitungen L1, L2, R1, R2 in Figur 1 dienen also zweierlei Funktionen: Einerseits bilden sie zusammen mit den acht Transistoren T1 bis T8 eine Multiplexer, über den wahlweise das linke oder das rechte Bitleitungspaar auswählbar ist. Zum anderen ermöglichen sie in der zweiten Betriebsart das Vertauschen der Leitungen des jeweils ausgewählten Bitleitungspaares bezüglich der Anschlüsse des primären Leseverstärkers SA. Somit ergibt sich für die Realisierung der Multiplexerfunktion und der Schaltfunktion der Schalteinheit SW durch die zweifache Ausnutzung der acht Transistoren ein geringer Aufwand an Schaltungselementen und Fläche.

Bei dem hier betrachteten Ausführungsbeispiel weist das Plattenpotential V_{P} in Figur 4 in beiden Betriebsarten einen Pegel V_{CC}/2 auf, der in beiden Betriebsarten genau zwischen zwei Versorgungspotentialen V_{CC}, Masse des Speichers liegt. In der zweiten Betriebsart wird die Versorgungsspannung des Speichers gegenüber der ersten Betriebsart erhöht, so daß auch die vom Leseverstärker SA auf das Bitleitungspaar BLL, /BLL gegebenen Signale einen höheren Signalhub haben. Daher werden in der zweiten Betriebsart an den Speicherkondensator C der Speicherzelle MC Spannungen angelegt, die gegenüber der ersten Betriebsart höher sind und die durch Änderung des Schaltzustandes der Schalteinheit SW ständig ihr Vorzeichen wechseln. Auf diese Weise erfolgt ein Entaltern der Speicherzelle.

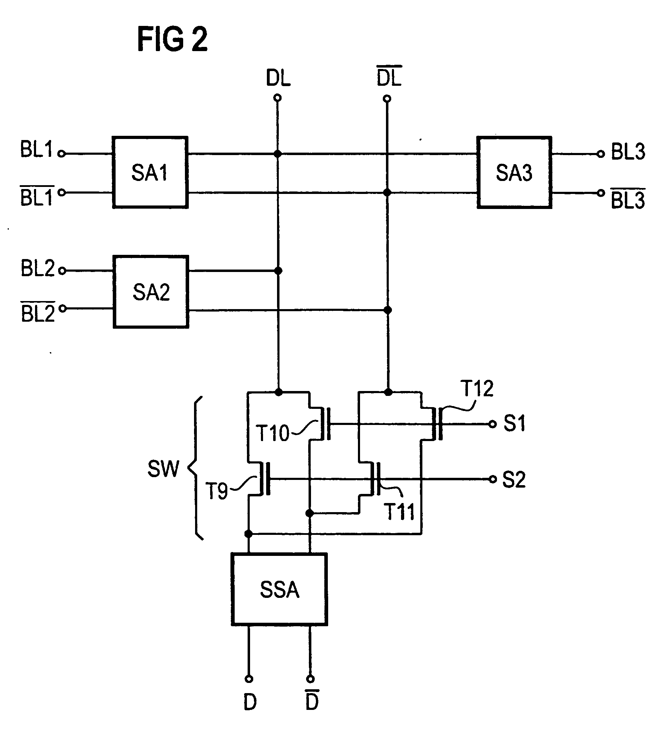

Figur 2 zeigt ein zweites Ausführungsbeispiel der Erfindung. Dargestellt sind drei differentielle primäre Leseverstärker SA1, SA2, SA3, die je einem Bitleitungspaar BL1, /BL1, BL2, /BL2 und BL3, /BL3 zugeordnet sind. Die primären Leseverstärker SAi sind mit einem gemeinsamen Datenleitungspaar DL, /DL verbunden, das über einen differentiellen sekundären Leseverstärker SSA mit einem externen Datenleitungspaar D, /D verbunden sind. Bei einem Lesezugriff auf eine dem ersten Bitleitungspaar BL1, /BL1 zugeordnete Speicherzelle wird auf dem Bitleitungspaar ein entsprechendes Differenzsignal erzeugt und vom primären Leseverstärker SA1 verstärkt zum Datenleitungspaar DL, /DL weitergegeben. Der sekundäre Leseverstärker SSA führt eine weitere Verstärkung des Differenzsignals durch und gibt es anschließend an das externe Datenleitungspaar D, /D weiter. Bei diesem Ausführungsbeispiel weist der Speicher eine Schalteinheit SW auf, die zum Vertauschen der Leitungen des Datenleitungspaares DL, /DL bezüglich der Anschlüsse des sekundären Leseverstärkers SSA dient. Die nicht invertierte Datenleitung DL ist über einen neunten Transistor T9 mit einem ersten Anschluß des sekundären Leseverstärkers und über einen zehnten Transistor T10 mit einem zweiten Anschluß des sekundären Leseverstärkers verbunden. Die invertierte Datenleitung /DL ist über einen elften Transistor T11 mit dem zweiten und über einen zwölften Transistor T12 mit dem ersten Anschluß des sekundären Leseverstärkers SSA verbunden. Die Gates des zehnten und des zwölften Transistors T10, T12 sind mit einer ersten Steuerleitung S1 und die Gates des neunten und elften Transistors T9, T11 sind mit einer zweiten Steuerleitung S2 verbunden. Die Ansteuerung der Schalteinheit SW in Figur 2 über die Steuerleitungen S1, S2 erfolgt in gleicher Weise wie die Ansteuerung der Schalteinheiten SW in Figur 1 über die Steuerleitungen L1, L2 beziehungsweise R1, R2.

Ebenso wie die primären Leseverstärker SA, SAi in den Figuren 1 und 2, ist der sekundäre Leseverstärker SSA in Figur 2 ein differentieller Leseverstärker, der aus den Speicherzellen MC ausgelesene Informationen beziehungsweise in diese einzuschreibende Informationen jeweils zwischenspeichert. Er kann ebenso wie die primären Leseverstärker aufgebaut sein. Während beim Ausführungsbeispiel aus Figur 1 für jedes Bitleitungspaar BLL, /BLL beziehungsweise BLR, /BLR eine Schalteinheit SW benötigt wird, um ein Auffrischen der mit ihnen verbundenen Speicherzellen durchzuführen, wird beim Ausführungsbeispiel gemäß Figur 2 nur eine Schalteinheit SW für alle Bitleitungspaare BLi, /BLi benötigt, die über ihre zugehörigen primären Leseverstärker SAi mit dem sekundären Leseverstärker SSA verbunden sind. Daher ergibt sich ein geringerer Hardware-Aufwand als beim Ausführungsbeispiel nach Figur 1. Weiterhin weist das Ausführungsbeispiel aus Figur 2 den Vorteil auf, daß sekundäre Leseverstärker üblicherweise dort angeordnet werden können, wo noch ausreichend Platz für zusätzliche Komponenten wie die Schalteinheit SW vorhanden ist. Dagegen werden primäre Leseverstärker möglichst nah bei den Speicherzellen MC angeordnet, deren Informationen sie verstärken sollen. Primäre Leseverstärker werden daher üblicherweise direkt im oder Rande eines Zellenfeldes angeordnet, wo es schwierig ist, zusätzliche Schaltungskomponenten wie diejenigen der Schalteinheiten SW unterzubringen.

Ein Entaltern der Speicherzellen MC beziehungsweise ein Auffrischen erfolgt bei den hier geschilderten Ausführungsbeispielen nur in der zweiten Betriebsart des Speichers. Dabei wird das Entaltern immer nach einer bestimmten Anzahl von erfolgten Schreibzugriffen durchgeführt. Zum Erfassen der Schreibzugriffe enthält der Speicher einen entsprechenden Zähler. Wird ein bestimmter Zählerstand erreicht, werden alle Speicherzellen MC des Speichers aufgefrischt, indem die in ihnen gespeicherte Information ausgelesen, zwischengespeichert und mit alternierenden Pegeln in die Speicherzelle zurückgeschrieben wird. Dabei ist bei diesen Ausführungsbeispielen die Anzahl der Wechsel des Schaltzustandes der Schalteinheiten SW geradzahlig, so daß mit Abschluß des Auffrischens wieder die ursprünglich in der Speicherzelle gespeicherte Information zurückgeschrieben wird.

## Patentansprüche

1. Integrierter Speicher mit beschreibbaren ferroelektrischen Speicherzellen (MC), die einen ferroelektrischen Speicherkondensator (C) zum Speichern einer Information aufweisen und die in einem Zellenfeld mit Bitleitungen (BL) und Wortleitung (WL) angeordnet sind,
- wobei die Speicherfähigkeit der Speicherzellen (MC) in Abhängigkeit von der Anzahl der durchgeführten Schreib- und/oder Lesezugriffe abnimmt,
- mit einem ersten und einem zweiten differentiellen Leseverstärker (SA) wobei der erste differentielle Leseverstärker Anschlüsse aufweist, die mit einem Datenleitungspaar (BLL, /BLL; DL, /DL) verbunden sind, über das der erste Leseverstärker bei einem Lesezugriff eine Information aus einer Speicherzelle ausliest, um sie anschließend zu verstärken, und über das er bei einem Schreibzugriff eine Information in eine der Speicherzellen einschreibt, wobei die betreffenden Informationen als Differenzsignale über das Datenleitungspaar übertragen werden und bei jedem Schreibzugriff vom ersten Leseverstärker zwischengespeichert werden,
- und mit einer Schalteinheit (SW), über die das Datenleitungspaar (BLL, /BLL; DL, /DL) mit den Anschlüssen des ersten Leseverstärkers (SA) verbunden ist, zum Vertauschen der Leitungen des Datenleitungspaares bezüglich der Anschlüsse des ersten Leseverstärkers in Abhängigkeit ihres Schaltzustandes,
- wobei sich der Schaltzustand der Schalteinheit (SW) während eines Schreibzugriffs wenigstens einmal ändert, so daß die einzuschreibende Information vom ersten Leseverstärker (SA) zunächst nicht invertiert und dann invertiert in die betreffende Speicherzelle (MC) eingeschrieben wird,
- wobei der Speicher eine erste Betriebsart aufweist, in der sich der Schaltzustand der Schalteinheit (SW) während eines Schreibzugriffs nicht ändert, und mit einer zweiten Betriebsart, in der sich der Schaltzustand der Schalteinheit während eines Schreibzugriffs wenigstens einmal ändert, wobei die erste Betriebsart eine Normalbetriebsart und die zweite Betriebsart eine Entalterungsbetriebsart ist,
- **dadurch gekennzeichnet, daß**
- die über dem Speicherkondensator (C) während eines Schreibzugriffs auf die jeweilige Speicherzelle (MC) abfallende Spannung in der zweiten Betriebsart höher ist als in der ersten Betriebsart,
- wobei die höhere Spannung **dadurch** bereitgestellt wird, daß der erste oder der zweite Leseverstärker in der zweiten Betriebsart mit einer höheren Versorgungsspannung versorgt ist.

2. Integrierter Speicher nach Anspruch 1, dessen Datenleitungspaar aus zweien der Bitleitungen (BLL, /BLL) gebildet ist und dessen erster Leseverstärker ein mit diesem Bitleitungspaar direkt verbundener primärer Leseverstärker (SA) ist.

3. Integrierter Speicher nach Anspruch 1,
- dessen erster Leseverstärker ein sekundärer Leseverstärker (SSA) ist
- und der wenigstens zwei zweite Leseverstärker (SA1, SA2) aufweist, die primäre Leseverstärker sind und einerseits über wenigstens je ein Paar der Bitleitungen (BL1, /BL1; BL2, /BL2) mit den Speicherzellen (MC) und andererseits über das Datenleitungspaar (DL, /DL) mit dem ersten Leseverstärker (SSA) verbunden sind.

4. Verfahren zum Entaltern einer der Speicherzellen (MC) eines integrierten Speichers nach einem der vorstehenden Ansprüche bei dem in der zweiten Betriebsart
- eine in der Speicherzelle (MC) gespeicherte Information ausgelesen und im ersten Leseverstärker (SA) zwischengespeichert wird
- und bei dem die im Leseverstärker (SA) zwischengespeicherte Information wenigstens zweimal in die Speicherzelle (MC) zurückgeschrieben wird, wobei nach jedem Zurückschreiben der Schaltzustand der Schalteinheit (SW) geändert wird
- und die über dem Speicherkondensator (C) während eines Schreibzugriffs auf die jeweilige Speicherzelle (MC) abfallende Spannung in der zweiten Betriebsart höher ist als in der ersten Betriebsart,
- wobei die höhere Spannung **dadurch** bereitgestellt wird, dass der erste oder der zweite Leseverstärker in der zweiten Betriebsart mit einer höheren Versorgungsspannung versorgt wird.

## Claims

1. Integrated memory having writeable ferroelectric memory cells (MC) which have a ferroelectric storage capacitor (C) for storing information and which are arranged in a cell array containing bit lines (BL) and word lines (WL),
- the storage capability of the memory cells (MC) being reduced on the basis of the number of read and/or write operations performed,
- having a first and a second differential sense amplifier (SA)
- the first differential sense amplifier having connections which are connected to a data line pair (BLL, /BLL; DL, /DL) via which the first sense amplifier, during a read access operation, reads information from a memory cell in order to amplify it subsequently, and via which, during a write access operation, said first sense amplifier writes information to one of the memory cells, the relevant information being transferred as differential signals via the data line pair and being temporarily stored by the first sense amplifier during every write access operation,
- and having a switching unit (SW), via which the data line pair (BLL, /BLL; DL, /DL) is connected to the connections of the first sense amplifier (SA), for interchanging the lines of the data line pair in relation to the connections of the first sense amplifier, depending on the switching state of said switching unit (SW),
- the switching state of the switching unit (SW) changing at least once during a write access operation, so that the information to be written is written to the relevant memory cell (MC) by the first sense amplifier (SA) firstly in noninverted form and then in inverted form,
- the memory having a first operating mode, in which the switching state of the switching unit (SW) does not change during a write access operation, and having a second operating mode, in which the switching state of the switching unit changes at least once during a write access operation, where the first operating mode is a normal operating mode and a second operating mode is an aging-prevention operating mode,
- **characterized in that**
- the voltage drop across the storage capacitor (C) during a write access operation to the respective memory cell (MC) is higher in the second operating mode than in the first operating mode,
- the higher voltage being provided by virtue of the first or the second sense amplifier being supplied with a higher supply voltage in the second operating mode.

2. Integrated memory according to Claim 1, whose data line pair is formed from two of the bit lines (BLL, /BLL) and whose first sense amplifier is a primary sense amplifier (SA) connected directly to this bit line pair.

3. Integrated memory according to Claim 1,
- whose first sense amplifier is a secondary sense amplifier (SSA),
- and which has at least two second sense amplifiers (SA1, SA2) which are primary sense amplifiers and are connected, firstly, via at least one respective pair of the bit lines (BL1, /BL1; BL2, /BL2) to the memory cells (MC) and, secondly, via the data line pair (DL, /DL) to the first sense amplifier (SSA).

4. Method for preventing aging in one of the memory cells (MC) in an integrated memory according to one of the preceding claims, in which, in the second operating mode,
- information stored in the memory cell (MC) is read and is temporarily stored in the first sense amplifier (SA),
- and in which the information temporarily stored in the sense amplifier (SA) is written back to the memory cell (MC) at least twice, the switching state of the switching unit (SW) being changed each time the information is written back,
- and the voltage drop across the storage capacitor (C) during a write access operation to the respective memory cell (MC) is higher in the second operating mode than in the first operating mode,
- the higher voltage being provided by virtue of the first or the second sense amplifier being supplied with a higher supply voltage in the second operating mode.

## Revendications

1. Mémoire intégrée ayant des cellules (MC) de mémoire ferroélectriques dans lesquelles on peut écrire, qui ont un condensateur (C) de mémoire ferroélectrique pour mémoriser une information et qui sont disposées dans un champ de cellules ayant des lignes (BL) de bit et une ligne (WL) de mot,
- dans laquelle la capacité de mémoire des cellules (MC) de mémoire diminue en fonction du nombre des accès en écriture et/ou en lecture effectués ;
- comprenant un premier et un deuxième amplificateurs (SA) différentiels de lecture, le premier amplificateur différentiel de lecture ayant des bornes qui sont reliées à une paire (BLL, /BLL ; DL, /DL) de conducteurs de données par laquelle le premier amplificateur de lecture lit, lors d'un accès en lecture, une information dans la cellule de mémoire pour ensuite l'amplifier et par laquelle il écrit, lors d'un accès en écriture, une information dans l'une des cellules de mémoire, les informations concernées étant transmises sous la forme de signaux de différence par la paire de lignes de données et étant mémorisées intermédiairement par le premier amplificateur de lecture à chaque accès en écriture ;
- et comprenant une unité (SW) de commutation par laquelle la paire (BLL, /BLL ; DL, /DL) de lignes de données est reliée aux bornes du premier amplificateur (SA) de lecture pour l'échange des lignes de la paire de lignes de données en ce qui concerne les bornes du premier amplificateur de lecture en fonction de son état de commutation ;
- dans laquelle l'état de commutation de l'unité (SW) de commutation se modifie au moins une fois pendant un accès en écriture, de sorte que l'information à écrire n'est pas inversée d'abord par le premier amplificateur (SA) de lecture, puis est écrite de façon inversée dans la cellule (MC) de mémoire concernée ;
- dans laquelle la mémoire a un premier type de fonctionnement dans lequel l'état de commutation de l'unité (SW) de commutation ne se modifie pas pendant un accès en écriture et un deuxième type de fonctionnement dans lequel l'état de commutation de l'unité de commutation se modifie au moins une fois pendant un accès en écriture, le premier type de fonctionnement étant un type de fonctionnement normal et le deuxième type de fonctionnement étant un type de fonctionnement de régénération ;
- **caractérisée en ce que**
- la tension chutant aux bornes du condensateur (C) de mémoire pendant un accès en écriture à la cellule (MC) de mémoire respective étant plus haute dans le deuxième type de fonctionnement que dans le premier type de fonctionnement ;
- dans laquelle la tension plus haute est procurée par le fait que le premier ou le deuxième amplificateur de lecture est alimenté dans le deuxième type de fonctionnement par une tension d'alimentation plus haute.

2. Mémoire intégrée suivant la revendication 1,
- dont la paire de lignes de données est formée de deux des lignes (BLL, /BLL) de bit et dont le premier amplificateur de lecture est un amplificateur (SA) de lecture primaire relié directement à cette paire de lignes de bit.

3. Mémoire intégrée suivant la revendication 1,
- dont le premier amplificateur de lecture est un amplificateur (SSA) de lecture secondaire ;
- et qui a au moins deux deuxièmes amplificateurs (SA1, SA2) de lecture qui sont des amplificateurs de lecture primaire et qui sont reliés d'une part par au moins, respectivement, une paire des lignes (BL1, /BL1; BL2, /BL2) de bit aux cellules (MC) de mémoire et d'autre part par la paire (DL, /DL) de ligne de données au premier amplificateur (SSA) de lecture.

4. Procédé de régénération de l'une des cellules (MC) d'une mémoire intégrée suivant l'une des revendications précédentes, dans lequel, dans le deuxième type de fonctionnement
- on lit une information mémorisée dans la cellule (MC) de mémoire et on la mémorise intermédiairement dans le premier amplificateur (SA) de lecture ;
- et dans lequel on réécrit l'information mémorisée intermédiairement dans l'amplificateur (SA) de lecture au moins deux fois dans la cellule (MC) de mémoire en modifiant après chaque réécriture l'état de commutation de l'unité (SW) de commutation ;
- et la tension chutant aux bornes du condensateur (C) de mémoire pendant un accès en écriture à la cellule (MC) respective de mémoire est plus haute dans le deuxième type de fonctionnement que dans le premier type de fonctionnement ;
- dans lequel on procure la tension plus haute par le fait que l'on alimente le premier ou le deuxième amplificateur de lecture dans le deuxième type de fonctionnement en une tension d'alimentation plus haute.
